# EUROPEAN PATENT APPLICATION

(11) **EP 1 136 597 A2**
(43) Date of publication of application: **26.09.2001**
(21) Application number: 01302405.4
(22) Date of filing: 15.03.2001
(51) Int. Cl.: C30B 33/00, C30B 29/06

(54) **Silicon surface oxidation device and method of fabricating optical waveguide substrate by the device**

(30) Priority: 15.03.2000 JP 2000071747; 15.03.2000 JP 2000071748
(71) Applicant: Shin-Etsu Chemical Co., Ltd., Chiyoda-ku, Tokyo 100-0004 (JP); SHIN-ETSU ENGINEERING Co., Ltd., Tokyo 101-0054 (JP)
(72) Inventor: Makikawa, Shinji, Fine Functional Materials Lab., Annaka-shi, Gunma 379-0127 (JP); Shirota, Masaaki, Fine Functional Materials Lab., Annaka-shi, Gunma 379-0127 (JP); Ejima, Seiki, Kita-Gun, Kagawa 761-0612 (JP); Hiroshi, Aoi, Fine Functional Materials Lab., Annaka-shi, Gunma 379-0127 (JP); Ohnoda, Tadatomo, Shin-Etsu Engineering Co., Ltd., Chiyoda-ku, Tokyo 101-0054 (JP)
(74) Representative: Bassett, Richard Simon

(57) **Abstract**

A silicon surface oxidation device utilizes a steam generator in which heated water is barely in contact with the members of the device, steam with no contamination is efficiently generated, and the silicon surface can be oxidized through relatively large thickness by using a steam oxidation method which is simple and high in safety. The steam generator has a feed port for pure water which flows along a surface in a chamber, an oscillator for oscillating a microwave toward the surface. a steam exit port for sending out the steam of the pure water generated from the surface by the microwave, and a discharge port for the pure water flowing along the surface. A heating furnace is connected to the steam exit port, and silicon placed in the heating furnace is oxidized by the steam generated by the microwave.

## Description

This invention relates to a silicon surface oxidation device adapted to oxidize a silicon surface through relatively large thickness and to a method of fabricating an optical waveguide substrate by this silicon surface oxidation device.

A waveguide device for optical communication is constructed with an optical waveguide and a semiconductor integrated circuit. The former is formed on a quartz substrate and the latter is on a silicon substrate. The quartz substrate is such that a quartz (silicon dioxide) film is formed on the surface of the silicon substrate. Since this film functions optically as the under-clad of the optical waveguide, it has a thickness of 5-30 µm which is much greater than a thickness of 0.5-3 µm of an oxidation film required for the semiconductor integrated circuit. To form the film, a flame hydrolysis deposition method that the soot of quartz synthesized by the effluence of oxyhydrogen flame and silicon oxide is deposited on a substrate and then is sintered has been used from the past.

Since silicon has a strong affinity with oxygen and is easily oxidized, the technique that silicon itself constituting the substrate is oxidized to form the quartz film is adopted for the formation of the oxidation film in the semiconductor integrated circuit. Such techniques are, for example, dry oxygen oxidation, wet oxidation, steam oxidation, hydrogen burning oxidation, and hydrochloride oxidation methods. A high-pressure oxidation method for reducing the forming time of the oxidation film by raising an oxygen pressure is also available.

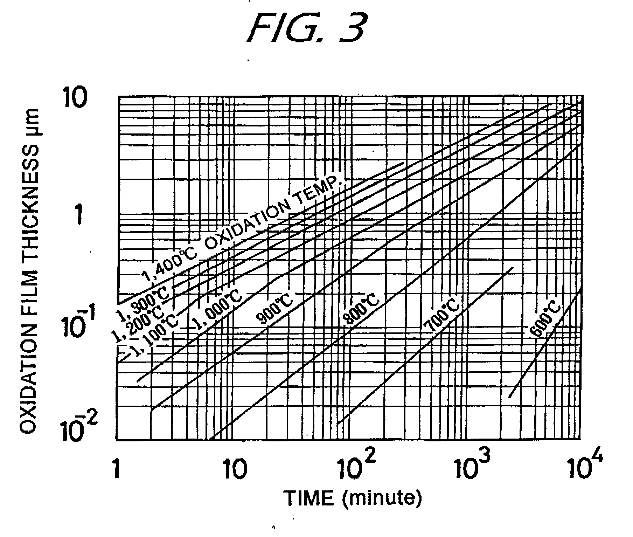

Of these oxidation methods, the steam oxidation method is to apply steam generated by heating pure water stored in a vessel to a heated silicon substrate and to form SiO₂ of the oxidation film. An oxidation rate in this method is relatively high. Fig. 3 shows the relationship between the thickness of the oxidation film and the oxidation time in the steam oxidation method, relative to various oxidation temperatures (heating temperatures of the silicon substrate). As seen from this graph, as the oxidation temperature increases, the oxidation rate becomes high. However, to form an oxidation film 5 µm thick, it takes at least 2000 minutes at an oxidation temperature of 1200 °C. Since the oxidation time is proportional to the square of the thickness of the oxidation film, the time required for formation of general-purpose oxidation films with thicknesses of 10-25 µm is 5000-50000 minutes.

In a conventional steam oxidation method, the temperature of the pure water in the vessel is maintained at 100 °C and thereby steam is generated. Thus, when heated and boiled water comes in contact with the vessel for a long time as mentioned above, components are mixed in the pure water from the vessel. Furthermore, the components adhere to the silicon substrate and become impurities of an optical waveguide substrate to be fabricated, constituting the cause of the degradation of performance. The utilization efficiency of energy dissipated by heating is not good.

It is a primary object of the present invention to provide a silicon surface oxidation device in which heated water is barely in contact with the members of the device, steam with no contamination is efficiently generated, and the silicon surface can be oxidized through relatively large thickness by using a steam oxidation method which is simpler in the structure of the oxidation device and higher in safety than the hydrogen burning oxidation method and the high-pressure oxidation method.

In order to achieve the primary object, a device for oxidizing silicon surface of the present invention comprises a feed port for pure water which flows along a upper surface of a plate in a chamber, an oscillator for oscillating a microwave toward the surface to generate steam from the pure water, a steam exit port for sending out the steam, and a discharge port for the pure water flowing along the surface. A heating furnace is connected to the steam exit port, and silicon placed in the heating furnace to be oxidized by the steam.

According to the device for oxidizing silicon surface, large quantity of the steam is fed into the heating furnace through the steam exit port at a short time, and thus silicon can be shortly oxidized. Between the feed of the pure water and the sending-out of the steam, the heated water is barely in contact with the members of the device.

It is a secondary object of the present invention to provide a device generating steam for oxidizing silicon surface, which has higher safety than prior oxidation devices operating by such as hydrogen burning oxidation method or high-pressure oxidation method.

In order to achieve the secondary object, the device generating steam for oxidizing silicon surface of the present invention comprises a control circuit for controlling a microwave output of said oscillator and a flow rate of said pure water flowing through said feed port by a temperature output of said thermo-sensor and a water detecting output of said water detecting sensor.

It is a third object of the present invention to provide a method of fabricating an optical waveguide substrate in which impurities are not mixed in the optical waveguide substrate to be fabricated and the dissipation of energy can be kept to a minimum to oxidize the silicon surface through relatively large thickness, by using a steam oxidation method which is higher in safety than the hydrogen burning oxidation method and the high-pressure oxidation method.

In order to achieve the third object, the method of fabricating the optical waveguide substrate of the present invention is such that heated silicon is exposed to steam and is oxidized to form a silicon dioxide film. The method comprises a step of a molecule of pure water continuously fed at not more than about room temperature is vibrated by the microwave, and the steam thus generated is supplied to the silicon.
Fig. 1 is a view showing a schematic construction relative to a steam generator and a silicon surface oxidation device according to the present invention;
Fig. 2 is a block diagram showing the control system of the steam generator; and
Fig. 3 is a graph showing the relationship between the thickness of the oxidation film and the oxidation time in the steam oxidation method.

The preferred embodiment of the present invention will be explained below with reference to the drawings. However, the scope of the claimed invention would not be limited by the embodiment.

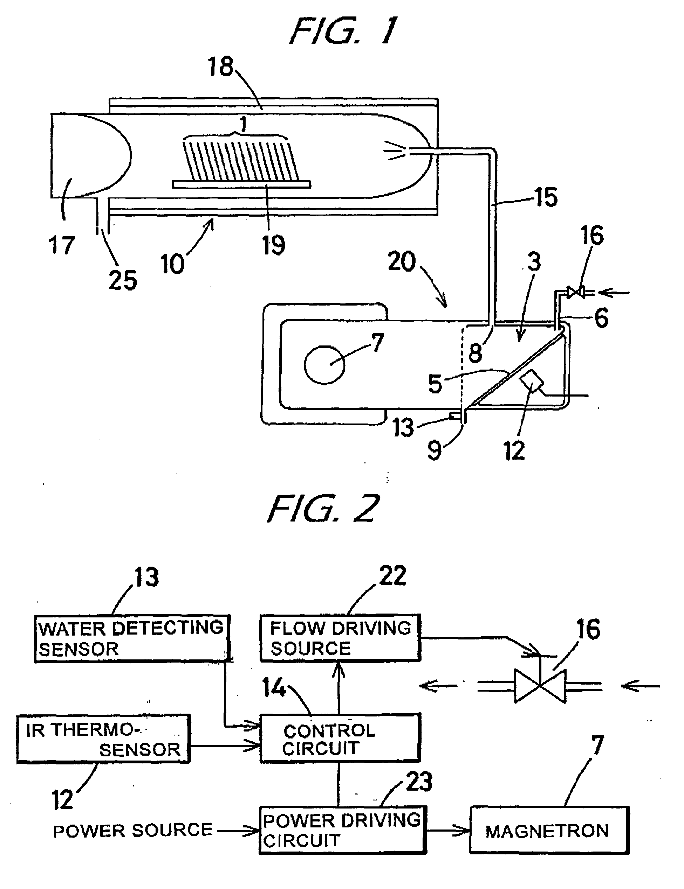

Fig. 1 shows the silicon surface oxidation device according to the present invention, together with the steam generator for silicon oxidation. As shown in Fig. 1, a heating furnace 10 for oxidizing a silicon 1 and a steam generator 20 are connected by a pipe 15 through which steam passes. A plate 5 made of porous quartz is obliquely placed in a quartz glass chamber 3 of the steam generator 20. The plate 5 is made by fusing and configuring quartz glass beads, its foaming ratio is about 20-80 %. Since quartz has no resonance structure with the microwave, the chamber 3 and the plate 5 will not be broken by heat. A magnetron is placed which oscillates a microwave of 2.45 GHz suitable for the excitation of molecule vibration of water, toward the oblique surface of the plate 5.

Above the oblique surface of the plate 5, a feed port 6 for pure water is provided, and a pipe connected to the feed port 6 is connected through a flowmeter 16 to a feed source of the pure water. Also, this pure water is used in the semiconductor industry and contains few impurities. The pure water is used as cooling water or room-temperature water if it is liquid. However, if the pure water has a high temperature, the components of a vessel may be dissolved by the high-temperature store of the pure water at a prestage to enter the pure water, which is unfavorable.

A discharge port 9 for the pure water is provided below the oblique surface of the plate 5. A steam exit port 8 provided toward the chamber 3 is connected to the pipe 15. In order to discharge generated steam copiously through the steam exit port 8 from the pipe 15, some gap is provided between the upper surface of the chamber 3 and the plate 5. An infrared thermo-sensor 12 is placed on the lower side of the oblique surface of the plate 5. At the discharge port 9, a photoelectric water detecting sensor 13 is located.

The heating furnace 10 assumes a cylindrical shape of a kanthal heater. A furnace core tube 18 of quartz is provided in the interior of the furnace, and a quartz plug 17 is put in the furnace core tube 18. A sample base 19 is placed in the furnace core tube 18 so that a plurality of silicon substrates 1 can be mounted in parallel thereon. Below the furnace core tube 18, a pressure releasing opening 25 is provided.

As shown in Fig. 2, the outputs of the thermo-sensor 12 and the water detecting sensor 13 are connected to a control circuit 14, and the control output of the control circuit 14 is connected to a flow driving source 22 and a power driving circuit 23 so that the output of a driving signal of the flow driving source 22 adjusts the flowmeter 16, while the power driving circuit 23 adjusts the driving power of the magnetron 7.

In the silicon surface oxidation device, in order to form a quartz film of large thickness on the silicon substrate, the silicon substrates are mounted in the furnace core tube 18, and the temperature of the heating furnace 10 is raised to a preset temperature by the kanthal heater. On the other hand, when the pure water is allowed to flow on the plate 5 by properly adjusting the flowmeter 16, the pure water spreads on the plate 5 and flows down while slightly penetrating into the plate 5, which is made of porous quartz, by the capillarity.

Here, when current is supplied from a power source through the power driving circuit 23 to the magnetron 7, the microwave is oscillated from the magnetron 7, and a molecule with a hydroxyl group (-OH) of the pure water flowing on the plate 5 is vibrated and heated, so that the steam is generated in a moment of time. The remaining pure water which has not been vaporized flows on the plate 5 and is discharged from the discharge port 9. The steam generated in the chamber 3 is fed from the steam exit port 8 through the pipe 15 into the furnace core tube 18. In the furnace core tube 18, the silicon substrates 1 are heated so that the surface of each of them reacts with the steam to form the film of SiO₂ (Si + 2H₂O → SiO₂ + 2H₂).

The quantity of the steam feeding into the furnace core tube 18 should be a rate of 0.001-0.50 L/cm²/minute in relation to the unit area of the surfaces of the silicon substrates 1 and the unit time. If the quantify of the feeding steam is poorer than the rate, the enough thickness of the silicon dioxide film may not be obtain in a short time. If the quantity of the feeding steam is richer than the rate, rare impurities in the rich pure water may be stored in the silicon dioxide film. The quantity should be controlled in the rate. When it makes to control a thickness of a silicon dioxide film, a time of the steam feeding should be increase or decrease in exponential rate to the objective thickness.

In a series of operation, when the water detecting sensor 13 detects the overage or shortage of discharged water, the control output is directed to the flow driving source 22 from the control circuit 14 to decrease or increase the amount of pure water flowing through the flowmeter 16. When the amount of pure water is decreased or increased, the temperature of the plate 5 is elevated or lowered and thus is detected by the thermo-sensor 12. In order to compensate the rise or drop of the temperature, the power of the power driving circuit 23 is decreased or increased by the output of the control circuit 14, and thereby the output of the microwave from the magnetron 7 is controlled. Hence, the amount of pure water is decreased or increased. When the amount of pure water is decreased or increased, the amount of pure water flowing on the plate 5 and the temperature of the plate 5 are properly adjusted.

The embodiment of the present invention in which the surface of the silicon substrate is oxidized by the silicon surface oxidation device and thereby a quartz substrate used for an optical waveguide is fabricated will be described below.

Sixteen 4 in. silicon substrates 1 are mounted in the furnace core tube 18 of the heating furnace 10, and the temperature of the heating furnace 10 is set at 1200 °C. It is assumed that the surface of each of the silicon substrates 1 is oxidized through a film thickness of 5 µm for 5000 minutes and steam of at least one liter per minute is fed from the chamber 3 to the furnace core tube 18. Thus, the amount of pure water to be supplied is set to one gram per minute in terms of 0 °C. In order to vaporize the pure water neither too much nor too less, a microwave output of 100 w is applied. Also, the inside dimension of the chamber 3 is 70 mm × 40 mm × 30 mm, and the inclination of the plate 5 of foamed quartz relative to a horizontal plane is 20°. In the device used for fabrication, the thermo-sensor 12 and the water detecting sensor 13 are mounted, but the circuits of the control system shown in Fig. 2 are not provided.

When the device is operated by the above settings, it is found that steam of 1.1 liters per minute is supplied to the furnace core tube 18. The detection temperature of the thermo-sensor 12 in this case is approximately 80 °C and is stable. The discharge water which is not initially detected is detected after 10 minutes by the water detecting sensor 13, and after 15 minutes, the temperature detected by the thermo-sensor 12 is lowered to about 75 °C. Hence, the power supplied to the magnetron 7 is somewhat increased so that a temperature of about 80 °C is maintained.

The temperature is adjusted as mentioned above, and the operation of the device is stopped after 2000 minutes to make natural cooling. After that, the 16 silicon substrates 1 which have been oxidized is taken out from the furnace. When thicknesses of oxidation films (quartz glass films) are examined under a microscope, it is found that the thicknesses are in the range of 5 ± 0.1 µm. When particles produced on the surfaces of the oxidation films are measured by a foreign matter examining device (provided from Hitachi Engineering Corporation), it is also found that the number of particles larger than 0.3 µm is as small as average less than 100 pieces per a substrate.

Also, the efficiency of the conversion from pure water to steam in the above operation is more than 90 %. When the pure water discharged from the chamber 3 after 5000 minutes is analyzed by a plasma radiation analyzer, Si less than 0.1 ppm is detected. The impurity of this kind, although very slight, seems to come from the chamber 3.

As has been described in detail, even when the silicon surface oxidation device of the present invention is operated for a long time, heated water is barely in contact with the members of the device. Hence, the silicon surface oxidation device is adapted to oxidize the silicon surface through relative large thickness and is capable of forming a silicon oxidation film which has very large thickness and no impurity.

## Claims

1. A device for oxidizing silicon surface comprising:
a feed port for pure water which flows along a upper surface of a plate in a chamber;
an oscillator for oscillating a microwave toward said surface to generate steam from said pure water;
a steam exit port for sending out said steam; and
a discharge port for said pure water flowing along said surface,
wherein a heating furnace is connected to said steam exit port, and silicon placed in said heating furnace to be oxidized by said steam.

2. The device for oxidizing silicon surface according to claim 1, wherein said plate is formed of quartz.

3. The device for oxidizing silicon surface according to claim 2, wherein said quartz contains foam in a range of 20 to 80 %.

4. The device for oxidizing silicon surface according to claim 1, wherein a thermo-sensor for detecting a temperature of said surface is placed.

5. The device for oxidizing silicon surface according to claim 1, wherein a water detecting sensor is placed in the proximity of said discharge port.

6. A device generating steam for oxidizing silicon surface comprising a control circuit for controlling a microwave output of said oscillator and a flow rate of said pure water flowing through said feed port by a temperature output of said thermo-sensor and a water detecting output of said water detecting sensor.

7. A method of fabricating the optical waveguide substrate in which heated silicon is exposed to steam and is oxidized to form a silicon dioxide film, comprising a step of a molecule of pure water continuously fed at not more than about room temperature is vibrated by a microwave, and said steam thus generated is supplied to said silicon.

8. The method of fabricating the optical waveguide substrate according to claim 7, wherein a heating temperature of said silicon is at least 1200 °C.

9. The method of fabricating the optical waveguide substrate according to claim 7, wherein an oscillation frequency of said microwave is approximately 2.45 GHz.

10. The method of fabricating the optical waveguide substrate according to claim 7, wherein a feed rate of said steam is 0.001-0.50 L/cm²/minute in relation to the unit area of the silicon surface to be oxidized and the unit time.
